Europäisches Patentamt

European Patent Office

Office européen des brevets

(19)

(11) Veröffentlichungsnummer: **0 009 099**
B1

(12) # EUROPÄISCHE PATENTSCHRIFT

(45) Veröffentlichungstag der Patentschrift: **19.05.82**

(21) Anmeldenummer: **79102720.4**

(22) Anmeldetag: **31.07.79**

(51) Int. Cl.³: **G 11 C 19/00,**
G 11 C 29/00

(54) Einrichtung zur Feststellung der Länge beliebiger Schieberegister.

(30) Priorität: **14.09.78 DE 2839950**

(43) Veröffentlichungstag der Anmeldung:
**02.04.80 Patentblatt 80/7**

(45) Bekanntmachung des Hinweises auf die Patenterteilung:
**19.05.82 Patentblatt 82/20**

(84) Benannte Vertragsstaaten:
**AT CH DE FR GB NL SE**

(56) Entgegenhaltungen:
**US - A - 3 398 403**

(73) Patentinhaber: **International Business Machines Corporation**
**Armonk, N.Y. 10504 (US)**

(72) Erfinder: **Drescher, Heinz**
**Zeisigweg 12**
**D-7031 Jettingen-U (DE)**
Erfinder: **Imbusch, Hinrich**
**Lenauweg 4**
**D-6500 Mainz 31 (DE)**
Erfinder: **Lampe, Hans Hermann**
**Werrastrasse 26**
**D-7033 Herrenberg (DE)**

(74) Vertreter: **Jost, Ottokarl, Dipl.-Ing.**
**Schönaicher Strasse 220**
**D-7030 Böblingen (DE)**

Courier Press, Leamington Spa, England.

Einrichtung zur Feststellung der Länge Beliebiger
Schieberegister

Die Erfindung betrifft eine Einrichtung zur Feststellung der Länge beliebiger Schieberegister nach dem Oberbegriff des Anspruchs 1.

Für die präzise Durchführung von Schreib- und Leseoperationen an Schieberegistern ist es eine notwendige Bedingung, die Länge dieser Schieberegister genau zu kennen.

Die Verwendung von Schieberegistern ist hinlänglich bekannt und sie spielt vor allem bei der Testbarkeit solcher logischer Schaltungen eine in zunehmendem Maße wichtige Rolle, die in höchster Integrationsdichte auf Halbleiterplättchen (LSI-Chips) hergestellt worden sind. Ein- und Ausgänge dieser logischen Schaltungen führen jeweils über Verriegelungsschaltungen, in denen deren Eingangs- und Ausgangsinformation festgehalten werden kann. Auf Grund des notorischen Mangels an Anschlüssen zur äußeren Welt werden diese Ein- und Ausgangsverriegelungsschaltungen auf einem Halbleiterplättchen zu Schieberegistern zusammengeschaltet, wobei eine solche Verriegelungsschaltung eine Stufe dieses Schieberegisters bildet. Die Anzahl der Verriegelungsschaltungen auf einem Halbleiterplättchen und damit die Länge des Schieberegisters ist sehr unterschiedlich und unterliegt keiner Gesetzmäßigkeit.

Beim normalen Betrieb der Schaltungen auf dem Halbleiterplättchen werden die Ein- und Ausgangsverriegelungsschaltungen in der Regel nicht zu Schieberegistern zusammengeschaltet; dieses ist normalerweise nur dem Prüfbetrieb vorbehalten. Sowohl für das Prüfen von neu entwickelten Schaltungen als auch für die Fehlersuche an installierten Systemen wird somit ein Schieberegisterwerkzeug benötigt, das ein beliebiges Manipulieren mit diesen Schieberegistern ermöglicht.

Es werden im wesentlichen zwei grundsätzliche Funktionen benötigt:

— Auslesen von Schieberegistern und Sichtbarmachung des in ihnen gespeicherten Inhalts
— Schreiben (oder Setzen) von frei wählbaren Mustern in diese Schieberegister.

Da, wie bereits erwähnt wurde, solche Manipulationen an Schieberegistern die Kenntnis der Länge des Schieberegisters voraussetzt, muß entweder vor dem Schieben angegeben werden, wie lang ein Schieberegister ist, oder es müssen im Schieberegisterwerkzeug feste Längen für bestimmte Schieberegister vorgegeben werden.

Während das erste Vorgehen den Nachteil der Gefahr einer Fehlbedienung in sich birgt und außerdem unbequem ist, muß bei letzterem jede Änderung einer Länge eines Schieberegisters von einer gleichzeitigen Änderung des Schieberegisterwerkzeugs begleitet sein. Der Nachteil hier ist eine außerordentliche Inflexibilität bei den genannten Anwendungen, bei denen ja bekanntlich auf den Halbleiterplättchen Schieberegister unbekannter und stark unterschiedlicher Länge gebildet werden.

Es ist daher die Aufgabe der vorliegenden Erfindung, ein Schieberegisterwerkzeug anzugeben, das es erlaubt, Schieberegister beliebiger unbekannter Länge sowohl lesen als auch schreiben zu können.

Gelöst wird diese Aufgabe der Erfindung durch die im Hauptanspruch angegebenen Merkmale.

Vorteilhafte Ausgestaltungen und Weiterbildungen des Gegenstandes der Erfindung sind den Unteransprüchen zu entnehmen.

Durch die Erfindung wird also im wesentlichen der Vorteil erreicht, daß infolge der vorgeschlagenen automatischen Bestimmbarkeit der Länge unbekannter Schieberegister ein universell verwendbares Schieberegisterwerkzeug aufgebaut werden kann, dessen Einsatz vor allem bei der Prüfung von hochintegrierten Schaltkreisen mit stets wechselnden Schieberegisterlängen große Vorteile mit sich bringt.

Im folgenden wird die Erfindung anhand eines durch Zeichnungen erläuterten Ausführungsbeispieles näher beschrieben.

Es zeigen:

Fig. 1 eine Darstellung des Prinzips für das Lesen und Schreiben von Schieberegistern unbekannter Länge,

Fig. 2 das Blockschaltbild einer Steuerung für das Lesen und Schreiben von Schieberegistern unbekannter Länge,

Fig. 3 das Blockschaltbild eines Schiebeimpulsgenerators,

Fig. 4 das Blockschaltbild eines Nachschiebemustergenerators,

Fig. 5 das Blockschaltbild einer Übertragungssteuerung und

Fign. 6 bis 8 Blockschaltbilder von in der Übertragungssteuerung nach Fig. 5 verwendeten Übertragungselementen.

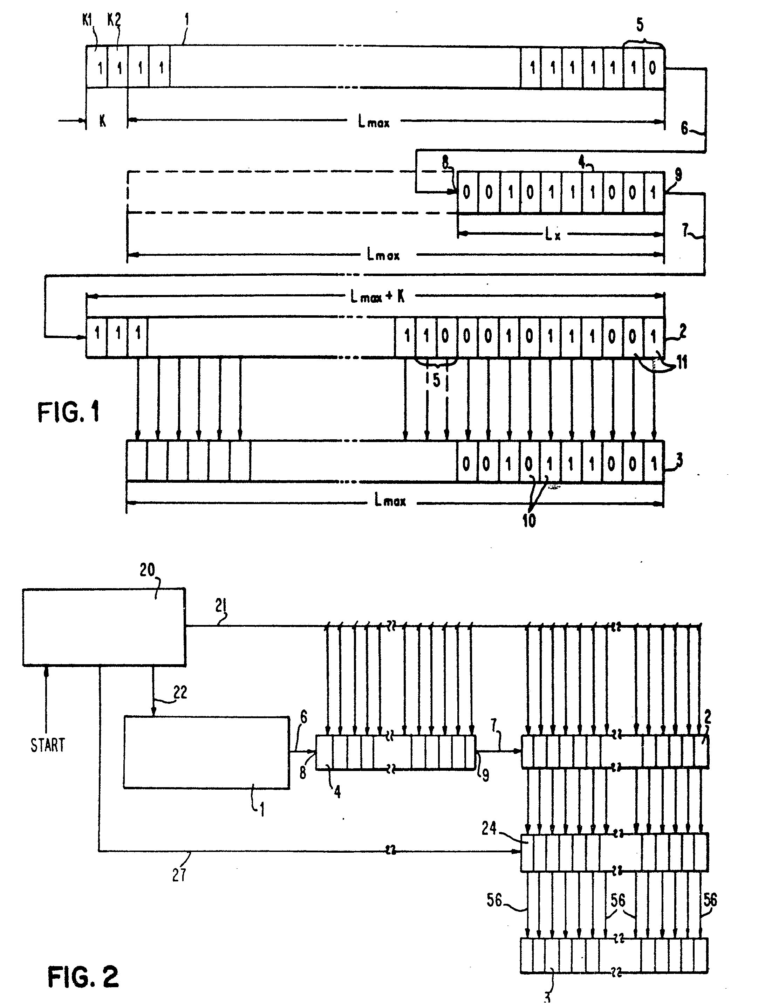

Fig. 1 zeigt im Prinzip eine Einrichtung, die es erlaubt, Schieberegister beliebiger unbekannter Länge sowohl lesen als auch schreiben zu können.

Bei einer systematischen Betrachtung der Einschreibvorgänge in solche Schieberegister ergeben sich im wesentlichen drei Möglichkeiten:

A) Die Länge des einzuschreibenden Musters stimmt mit der Länge des Schieberegisters genau überein. Dieses ist der einfachste Fall, der keine zusätzlichen Maßnahmen erfordert.

B) Das einzuschreibende Muster ist länger als das Schieberegister. Hierbei soll angezeigt werden, wie weit das Muster eingeschrieben werden konnte.

C) Das einzuschreibende Muster ist kürzer als das Schieberegister. Hierbei kann das Schreiben verhindert werden oder alternativ das kürzere Muster mit einem homogenen Muster ergänzt werden.

Das Auslesen von Schieberegistern unbekannter Länge und die Bestimmung der jeweiligen Länge unterliegt ebenfalls den eingangs erwähnten Schwierigkeiten, die aber mit dem in Fig. 1 dargestellten Prinzip gelöst werden können.

Es wird bei der Einrichtung nach Fig. 1 davon ausgegangen, daß die Schieberegister 4 der unbekannten Länge Lx, mit denen und an denen manipuliert werden soll, von endlicher Länge sind. Es wird dabei weiter vorausgesetzt, daß die größte unbekannte Länge Lmax dieser Schieberegister nicht überschritten wird. Im Schieberegisterwerkzeug nach Fig. 1 ist eine Anordnung 1 vorgesehen, die ein Nachschiebemuster der Länge Lmax +K erzeugt, wobei K≥2 sein muß. Als Anordnung 1 kann beispielsweise ein Schieberegister der Länge Lmax +K verwendet werden.

Das Nachschiebemuster ist homogen bis auf einen Sprung 5 am rechten Ende der Anordnung 1. Besteht das homogene Muster aus lauter Einsen, dann ist der Sprung ein Übergang von Eins auf Null derart, daß sich in der am weitesten rechts befindlichen Position des Schieberegisters die binäre Null befindet. Es ist im Prinzip auch möglich, als homogenes Muster lauter Nullen zu verwenden, wobei der Sprung 5 dann so realisiert ist, daß die am weitesten rechts befindliche Position eine binäre Eins enthält.

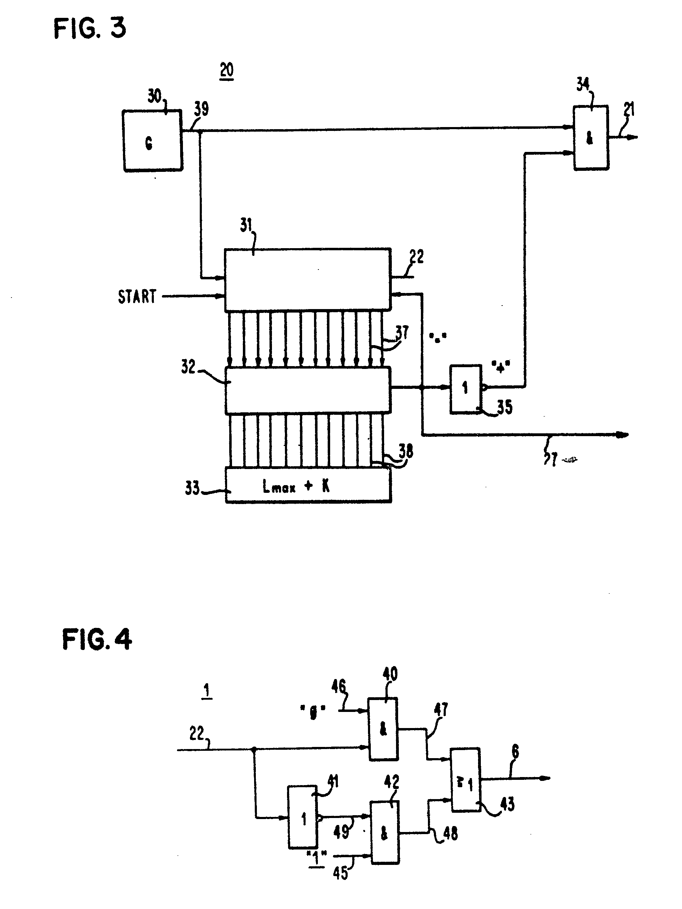

Durch das Zuführen von Schiebeimpulsen über die in Fig. 1 nicht dargestellte Schiebeleitung wird der Inhalt des Schieberegisters 4 unbekannter Länge über die Datenleitung 7 in den Speicher 2, möglicherweise ebenfalls ein Schieberegister, übertragen und von links mit dem Nachschiebemuster aufgefüllt, das ebenfalls durch Zuführen von Schiebeimpulsen über die Leitung 6 und durch das Schieberegister 4 in den Speicher 2 gelangt. Die Länge dieses Speichers 2 ist ebenfalls Lmax +K. Die Anzahl der von einem in den Fign. 2 und 3 dargestellten Scheibeimpulsgenerator 20 erzeugten Schiebeimpulse wird mit Lmax +K gewählt, so daß mit Sicherheit der gesamte Inhalt des unbekannten Schieberegisters 4 und ein Teil des Nachschiebemusters in den Speicher 2 gelangt. Die Größe dieses Teiles kann mit Lmax +K −Lx angegeben werden.

Als nächstes wird nun im Speicher 2 von links nach rechts der Datensprung 5 gesucht. Eine Stelle rechts neben diesem Sprung steht dann das erste oder letzte Bit, je nach Betrachtungsweise, des Dateninhalts des unbekannten Schieberegisters 4.

Da der Anfang des Speichers 2 bekannt ist, kann der Inhalt des unbekannten Schieberegisters 4 in richtiger Länge in das Anzeigefeld 3 übernommen werden.

Bei einem (links) offenen Schieberegister sind die Verhältnisse besonders schwierig. Ein solches offenes Schieberegister wird zwar automatisch von der Einrichtung nach Fig. 1 mit einem homogenen Muster aufgefüllt, das aus binären Nullen oder Einsen besteht, je nachdem ob es sich bei dem zur Realisierung der Schieberegisterzellen verwendeten logischen Schaltungen (UND oder NAND) am (linken) offenen Ende um solche mit positiver oder negativer Logik handelt.

Es kann jedoch bei einem offenen Schieberegister seine Länge nicht festgestellt werden, da die im Schieberegister links stehenden Bits den gleichen Wert wie das nachgeschobene Muster haben können. Es ist somit für eine Längenbestimmung unerläßlich, daß ein Nachschiebemuster mit einem identifizierbaren Sprung in der Datenkonfiguration in das unbekannte Schieberegister geschoben wird.

Mit Hilfe der in Fig. 1 dargestellten Einrichtung ist auch die Fehlerprüfung von unbekannten Schieberegistern möglich. Falls nämlich beim Durchsuchen des Speichers 2 kein Sprung 5 oder kein Teil des Nachschiebemusters gefunden werden kann, ist das unbekannte Schieberegister mit Sicherheit defekt.

Die Einrichtung nach Fig. 1 erlaubt auch das Schreiben von Schieberegistern unbekannter Länge und die Nachprüfung des Schreibvorgangs auf Fehlerfreiheit.

Es wird hierzu zunächst die Länge Lx des unbekannten Schieberegisters auf die zuvor erläuterte Weise bestimmt. Danach wird das vorgegebene Muster bis zur ermittelten Länge in das Schieberegister 4 eingeschrieben. Danach wird im vorgegebenen Muster markiert, bis zu welcher Stelle dieses Muster in das Schieberegister 4 eingeschrieben werden konnte.

Beim Prüfvorgang wird das eingeschriebene Muster aus dem Schieberegister 4 zurückgelesen und mit dem vorgegebenen Muster verglichen. Bei Abweichungen werden die betreffenden Stellen markiert.

Bei der Manipulation mit Schieberegistern einer Datenverarbeitungsanlage, die über eine Konsole und einen Bildschirm verfügt, kann der Bildschirm als Anzeigefeld 3 verwendet werden. Hierbei können Bitmuster als Eins oder Null dargestellt werden. Schieberegister-Endstellen können durch einen Stern (*), falsch eingeschriebene Bits mit einem Pluszeichen (+) für ein zusätzliches Bit oder mit einem Minuszeichen (−) für ein fehlendes Bit markiert werden.

Wie bei der Erläuterung des Prinzips anhand der Fig. 1 schon ausgeführt wurde, soll der Inhalt des Prüflings, also des Schieberegisters 4 unbekannter Länge, mittels des Anzeigefeldes 3, das seinem Prinzip nach ein Ergebnisspeicher ist, angezeigt werden. Der Prüfling selbst sowie der Speicher 2, der seiner Funktion nach ein Zwischenspeicher ist, sind übliche Schieberegister, deren Stufen 11 (Fig. 1) aus Verriegelungsschaltungen oder Flipflops gebildet sind.

Die zum Schieben notwendigen Schiebeimpulse der Zahl Lmax +K werden in der in Fig. 2 dargestellten Einrichtung vom Schiebeimpulsgenerator 20 erzeugt und über die Leitung 21 sowohl zu dem Prüfling 4 als auch zu dem Speicher 2 übertragen.

Ein Nachschiebemustergenerator 1 erzeugt das Nachschiebemuster und überträgt dieses über die Leitung 6 zum Prüfling 4. Für die Erzeugung des Nachschiebemusters benötigt der Nachschiebemustergenerator 1 ein Signal, das mit Schritt "1" bezeichnet ist und über die Leitung 22 vom Schiebeimpulsgenerator 20 zum Nachschiebemustergenerator 1 übertragen wird.

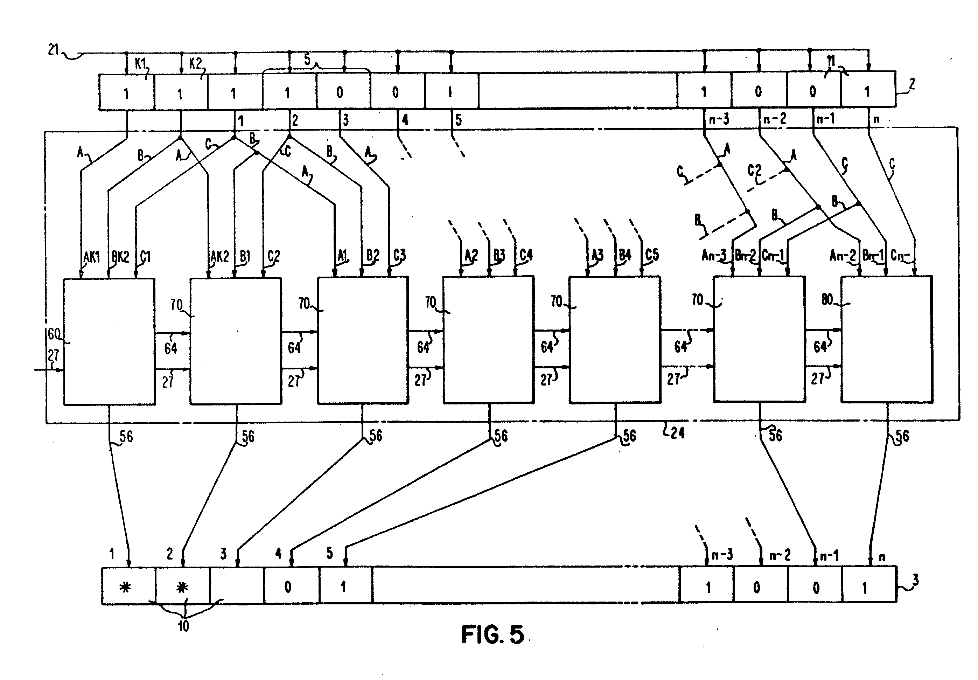

Nach Abschluß des Schiebevorgangs wird durch eine Übertragungssteuerung 24, die durch einen Übertragungsimpuls gesteuert wird, der vom Schiebeimpulsgenerator 20 über die Leitung 27 zur Übertragungssteuerung 24 übertragen wird, der sich im Speicher 2 befindliche Inhalt des Prüflings 4 (und nur dieser) mittels der in der Übertragungssteuerung 24 enthaltenen Übertragungselemente 60, 70, 80 (Fig. 5) über die Leitungen 56 in das Anzeigefeld 3 übertragen.

Die Wirkungsweise dieser in Fig. 2 dargestellten Einrichtung wird bei der nun folgenden Beschreibung des Schiebeimpulsgenerators 20, das Nachschiebemustergenerators 1 und der Übertragungssteuerung 24 deutlicher. Der Schiebeimpulsgenerator 20 verfügt, wie Fig. 3 zeigt, über einen Oszillator 30, der über die Leitung 39 Rechteckimpulse einer geeigneten Taktfrequenz zu dem einen von zwei Eingängen des UND-Tores 34 überträgt. Wenn dieses UND-Tor 34 geöffnet ist, gibt es über seine Ausgangsleitung 21 die Schiebeimpulse zur Verschiebung der im Prüfling 4 und dem Speicher 2 enthaltenen Information ab.

Die Anzahl Lmax +K der Schiebeimpulse wird von einem Zähler 31 mit zugeordnetem Vergleicher 32 bestimmt. Zu Beginn der Operation stellt das Startsignal den Zähler 31 auf den Anfangswert Null ein. Danach wird er von den Impulsen des Oszillators 30 über die Leitung 39, die ja auch, wie bereits erwähnt wurde, die Schiebeimpulse darstellen, hochgezählt. Der Vergleicher 32, der mit den Stufen des Zählers 31 über die Leitungen 37 verbunden ist, vergleicht laufend den jeweiligen Zählerstand mit dem in einem Speicher 33 gespeicherten Festwert Lmax +K, der ihm über die Leitungen 38 mitgeteilt wird.

Beim Erreichen des maximalen Zählerstandes Lmax +K wird der über die Leitung 27 zu dem Negator 35 übertragene Ausgangsimpuls invertiert, so daß dieses invertierte Ausgangssignal, das den zweiten Eingang des UND-Tores 34 bildet, dieses Tor sperrt. Dieses bedeutet auch das Ende der Übertragung von Schiebeimpulsen des Oszillators 30 über die Leitung 21.

Gleichzeitig löst der Ausgangsimpuls des Vergleichers 32, der über die Leitung 27 als Übertragungsimpuls übertragen wird, die Übertragungssteuerung 24 aus.

Schließlich wird auch das Ausgangssignal des Vergleichers, das beim Erreichen des Zählerstandes Lmax +K erzeugt wird, über die Leitung 27 mit der Absicht zu dem Zähler 31 übertragen, diesen gegen ein weiteres Hochzählen zu sperren.

Der in Fig. 4 dargestellte Nachschiebemustergenerator 1 erzeugt für den ersten Schiebeschritt durch das Signal "Schritt Eins", das über die Leitung 22 von der ersten Stufe des Zählers 31 in Fig. 3 übertragen wird, mittels des UND-Tores 40, der Übertragungsleitung 47 und des ODER-Tores 43, das Bit Null des Nachschiebemusters, das über die Leitung 6 zu dem Prüfling 4 übertragen wird.

Für alle weiteren Verschiebeschritte werden über den Negator 41, das UND-Tor 42, die Übertragungsleitung 48 und das ODER-Tor 43 die Einserbits des Nachschiebemusters erzeugt und über die Leitung 6 übertragen.

Für die Erzeugung des Null-Bits des Nachschiebemusters durch das UND-Tor 40 ist entscheidend, daß an seinem Eingang 46 stets der einer binären Null zugeordnete Pegel anliegt. Analog hierzu ist für das UND-Tor 42, welches die Einserbits erzeugt, das Anliegen eines der binären Eins entsprechenden Pegels am Eingang 45 entscheidend. Die genannten Pegel können beispielsweise durch feste Verdrahtung konstant eingestellt werden oder aber über eine besondere Steuerschaltung, die nicht dargestellt ist und die die Aufgabe hat, die homogenen Bits des Nachschiebemusters wahlweise als Nullen oder als Einsen auszugeben, wobei dann zur Realisierung des Sprungs die äußerste rechte Bitstelle des Nachschiebemusters die umgekehrte binäre Wertigkeit haben muß.

Der Schiebeimpulsgenerator 20 und der Nachschiebemustergenerator 1 sorgen also für die Erzeugung der Schiebeimpulse und des Nachschiebemusters, die für die Übertragung der Information des Prüflings 4 in den Speicher 2 (Zwischenspeicher) erforderlich sind.

Für die Übertragung des im Speicher 2 enthaltenen Bitmusters, das sich aus dem Bitmuster der Prüflings und einem Teil des Nachschiebemusters zusammensetzt, in das Anzeigefeld 3, dient die in Fig. 5 näher dargestellte Übertragungssteuerung 24, die aber den Datensprung 5 und den Rest des Nachschiebemusters unterdrückt, so daß diese nicht dargestellt werden.

Diese Übertragungssteuerung 24 besteht aus einem Übertragungselement 60, das einen von der Mehrzahl der Übertragungselemente 70 abweichenden Aufbau hat und der Position 1 sowohl des Speichers 2 als auch des Anzeigefeldes 3 zugeordnet und zwischen die beiden Speicherzellen der genannten Position geschaltet ist, sowie aus Übertragungselementen 70, die den jeweiligen Positionen 2 bits n-1 zugeordnet sind, und schließlich aus einem ebenfalls in seinem Aufbau von den Übertragungselementen 70 abweichenden Bauelement 80, das zwischen Speicherzelle und Anzeigefeld der letzten Position n geschaltet ist. Es sei der Vollständigkeit wegen erwähnt, daß in diesem Fall Lmax=n ist.

Die Übertragungselemente 60, 70 und 80 ermitteln von links nach rechts den ersten Datensprung, der beispielsweise in Fig. 1 dargestellt ist und die Konfiguration 1/0 hat. Hat eine dieser Schaltungen einen solchen Sprung identifiziert, dann teilt sie diese Information allen weiter rechts liegenden Übertragungselementen mit, um den gespeicherten Inhalt des Prüflings aus dem Speicher 2 in das Anzeigefeld 3 zu übertragen.

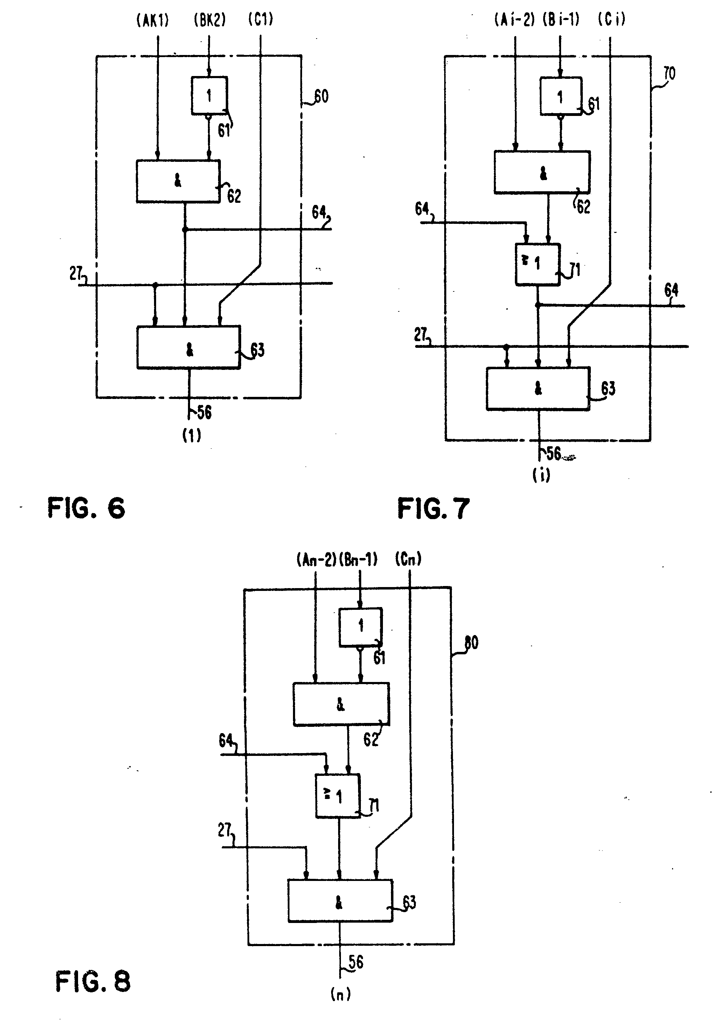

Die Wirkungsweise der Übertragungselemente sei anhand eines Übertragungselementes 70 erläutert, das in Fig. 7 dargestellt ist. Bei einem Eingang Ai-2=1 und einem Eingang Bi-1=0, also einem Datensprung, wird über den Negator 61 und das UND-Tor 62 das ODER-Tor 71 aktiviert. Ferner wird über das UND-Tor 63 das jeweilige Bit der Position i im Speicher 2 in die Position i im Anzeigefeld 3 übertragen, wenn außerdem auf der Leitung 27 der vom Schiebeimpulsgenerator 20 erzeugte Übertragungsimpuls vorliegt.

Die Erkennung des 1/0-Sprunges in den Positionen i-2 und i-1 wird den Übertragungselementen für die Positionen >i über die Ausgangsleitung 64 mitgeteilt, womit unabhängig von den UND-Toren 62 der rechts nachfolgenden übertragungselemente 70 bzw. 80, deren ODER-Tore 71 durch das Steuersignal auf der Leitung 64 durchgeschaltet werden. Auf diese Weise gelangt die Information aus den Positionen i bis n des Speichers 2 in die Positionen i bis n des Anzeigefeldes 3, und zwar zu dem Zeitpunkt, zu dem der übertragungsimpuls über die Leitung 27 gesendet wird.

Für diese von links nach rechts erfolgende Ermittlung des 1/0-Sprungs gibt es Ausgangsleitungen des Speichers 2, die, je nach Position, als einfache Leitung, als Zweifach- oder Dreifachleitungen geschaltet sind. Die einfachen Leitungen sind nur mit A, die Zweifachleitungen sind mit A und B und die Dreifachleitungen mit A, B und C bezeichnet. Im systematischen Aufbau dieses Systemes ergibt sich, daß die erste Stufe K1 des Speichers nur eine Einfachleitung A, die zweite Stufe K2 eine Zweifachleitung A, B und die dritte Stufe 1 bis zur vorvorletzten Stufe n-2 Dreifachleitungen A, B und C haben, die vorletzte Stufe n-1 auslaufend eine Zweifachleitung von B und C und die letzte Stufe n nur noch eine Einfachleitung C aufweisen.

Die Stufen K1 und K2, die der Vorschrift K≥2 entsprechen, dienen der Sicherstellung, daß ausgehend von einer zugelassenen Maximallänge Lmax noch mit Sicherheit der Datensprung identifiziert werden kann, für den zwei zusätzliche Positionen für 0 und 1 genügen.

Bei einem Prüfling 4 der Länge Lmax=n muß also bei fehlerfreier Länge in der Stufe K2 eine binäre Null und in der Stufe K1 eine binäre Eins vorgefunden werden. Kann dieser Sprung in der Datenkonfiguration links neben der ersten Stufe des Speichers 2 nicht festgestellt werden, dann kann eine nicht dargestellte, aber an den Leitungen AK1 und BK2 angeschlossene Fehlerschaltung dieses durch ein Fehlersignal melden.

Zum leichteren Diagnostizieren von Schieberegistern unbekannter Länge, also von Prüflingen 4, können die Übertragungselemente 60, 70 und 80 mit nicht dargestellten Schaltungsmitteln versehen sein, um im Anzeigefeld 3 stets links der jeweils festgestellten Länge ein Stern- oder ein anderes geeignetes Symbol einzuschreiben bzw. optisch darzustellen.

**Patentansprüche**

1. Einrichtung zur Feststellung der Länge Lx beliebiger Schieberegister (Prüflinge), die eine vorgegebene maximale Länge Lmax nicht überschreiten, gekennzeichnet durch folgende Merkmale:

— eine an den Eingang (8; Fig. 1) des Prüflings (4) angeschlossene Anordnung (1) zur Erzeugung eines Nachschiebemusters der Länge Lmax +K, mit K≥2, das aus einer definierten Bitkonfiguration (z. B. lauter binäre Einsen) mit einem definierten Datensprung (5) an seinem dem Prüfling zugewandten Ende besteht und das durch den Prüfling hindurchgeschoben wird,

— einen Speicher (2) der Länge Lmax +K, der an den Ausgang (9) des Prüflings angeschlossen ist und beim Verschieben des Nachschiebemusters die Information der Länge Lx des Prüflings und den Teil Lmax +K −Lx des Nachschiebemusters aufnimmt und

— ein Anzeigefeld (3), dessen Einzelfelder (10) jeweils einer Speicherzelle (11) des Speichers (2) fest zugeordnet sind und das deren Inhalt angibt, so daß der Datensprung (5) und damit das Ende und die Länge Lx des Prüflings feststellbar sind.

2. Einrichtung nach Anspruch 1, dadurch gekennzeichnet, daß zwischen den Speicher (2; Fig. 2) und das Anzeigefeld (3) eine Übertragungssteuerung (24) geschaltet ist, die nur den Inhalt des Prüflings in das Anzeigefeld überträgt und das Nachschiebemuster einschließlich des Datensprungs (5) unterdrückt.

3. Einrichtung nach Anspruch 1 und/oder 2, dadurch gekennzeichnet, daß die Schiebeimpulse, welche das Durchschieben des Nachschiebemusters bzw. eines Teiles desselben und das Herausschieben der im Prüfling gespeicherten Information in den Speicher (2) steuern, von einem Schiebeimpulsgenerator (20; Fig. 3) erzeugt werden, der aus einem Oszillator (30) sowie einem mit seinem Ausgang verbundenen UND-Tor (34) besteht, dessen Ausgang (21) die Schiebeimpulse an den Prüfling und den Speicher anlegt, daß der Schiebeimpulsgenerator ferner aus einem Zähler (31) besteht, der über mindestens Lmax +K Zählstellungen verfügt und von den Impulsen des Oszillators (30) hochgezählt wird und der einen Ausgang (22) aufweist, der stets ein Signal abgibt, wenn der Zähler den ersten Zählwert Eins erzeugt, daß ferner der Zähler mit einer Vergleichseinrichtung (32, 33) verbunden ist, die bei Erreichen des Zählwertes Lmax +K ein Ausgangssignal abgibt, das den Zähler stillsetzt, über einen Negator (35) das UND-Tor (34) gegen die Übertragung weiterer Schiebeimpulse sperrt und als Übertragungsimpuls über eine Leitung (27) die Übertragungssteuerung (24) durchschaltet.

4. Einrichtung nach einem oder mehreren der Ansprüche 1 bis 3, dadurch gekennzeichnet, daß die Anordnung (1; Fig. 4) zur Erzeugung des Nachschiebemusters aus einem ersten UND-Tor (40) besteht, an dessen einem Eingang (46) fest ein der binären Null entsprechender Wert und an dessen anderem Eingang über die Ausgangsleitung (22) des Zählers (31) das dessen erste Zählstellung identifizierende Signal anliegen, daß ferner ein zweites UND-Tor (42) vorgesehen ist, an dessen einem Eingang (49) das über einen Negator (41) invertierte Signal zur Identifizierung des Schrittes Eins des Zählers und an dessen zweitem Eingang (45) fest ein der binären Eins entsprechendes Signal anliegen, und daß schließlich die Ausgänge des ersten und zweiten UND-Tores zu einem ODER-Tor (43) geführt sind, dessen Ausausgangsleitung (6) das Nachschiebemuster abgibt.

5. Anordnung nach einem oder mehreren der Ansprüche 2 bis 4, dadurch gekennzeichnet, daß die Übertragungssteuerung (24; Fig. 5), die zwischen den Speicher (2) und das Anzeigefeld (3) geschaltet ist, für jede Stelle (i) ein Übertragungselement (60, 70 oder 80) aufweist, das auf ein Übertragungssignal hin den Wert der ihm zugeordneten Stelle (i) aus dem Speicher in die entsprechende Stelle (i) im Anzeigefeld überträgt, wenn sich der ihm zugeordnete Wert in einer Stelle (i-p) rechts vom Datensprung (5) befindet, wobei der Wert p eine ganze Zahl zwischen K und n +K ist.

6. Einrichtung nach Anspruch 5, dadurch gekennzeichnet, daß das der ersten Position (i=1) zugeordnete Übertragungselement (60; Fig. 6) über drei Eingangsleitungen (A, B, C) verfügt, die den ersten drei Stufen (K1, K2, 1) zugeordnet sind und von denen die erste den einen Eingang eines ersten UND-Tores (62), die zweite den Eingang eines Negators (61), dessen Ausgang den anderen Eingang des ersten UND-Tores darstellt, und deren dritte den dritten Eingang eines zweiten UND-Tores (63) bilden, dessen zweiter Eingang vom Ausgang des ersten UND-Tores und dessen erster Eingang von der Übertragungsimpulsleitung (27) gebildet ist und dessen Ausgang (56) zur ersten Position des Anzeigefeldes (3) führt, wobei der Ausgang des ersten UND-Tores mit einer Ausgangsleitung (64) verbunden ist, die allen rechts benachbarten Übertragungselementen (70, 80) das Vorliegen eines vom ersten UND-Tor (62) festgestellten Datensprunges mitteilt, und wobei jeweils die dritte Eingangsleitung (C) die ihrer Speicherzelle im Speicher (2) zugeordnete Information in die zugeordnete Position im Anzeigefeld (3) überträgt, wenn diese Position sich rechts von einem Datensprung (5) befindet.

7. Einrichtung nach Anspruch 6, dadurch gekennzeichnet, daß in Abweichung von dem der ersten Position zugeordneten Übertragungselement (60) die Übertragungselemente (70, 80), die der zweiten bis nten Position zugeordnet sind, in der Verbindungsleitung des Ausgangs des ersten UND-Tores (62) zum zweiten Eingang des zweiten UND-Tores (63) ein ODER-Tor (71) derart zwischengeschaltet haben, daß der eine Eingang des ODER-Tores mit dem Ausgang des ersten UND-Tores und sein Ausgang mit dem zweiten Eingang des zweiten UND-Tores und die Verbindungsleitung (64) für die Mitteilung des Datensprunges mit dem anderen Eingang des ODER-Tores verbunden ist, und wobei die sich nach rechts fortsetzende Verbindungsleitung (64) mit dem Ausgang des ODER-Tores verbunden ist.

**Revendications**

1. Dispositif pour détecter la longueur Lx de registres à décalage quelconques (circuits à tester) qui ne dépassent pas une longueur Lmax prédéterminée, caractérisée par:

— un arrangement (1) connecté à l'entrée (8; Figure 1) du circuit à tester (4) pour produire une configuration de décalage d'une longueur Lmax +K, avec K≥2, qui est composée d'une configuration de bits définie (par exemple composée seulement de uns binaires) avec une transition de données (5) défini à son extrémité faisant face au circuit à tester et qui est décalée à travers le circuit à tester,

— une mémoire (2) de longueur Lmax +K, qui est connectée à la sortie (9) du circuit à tester et qui, lors du décalage de la configuration de décalage, reçoit l'information de longueur Lx de l'objet d'essai et la partie Lmax +K —Lx de la configuration de décalage, et

— un champ d'affichage (3) dont les champs individuels (10) sont chacun associés, de façon permanente, à une cellule de mémoire (11) de la mémoire (2), ce champ indiquant son contenu de telle sorte que la transition de données (5) et, par conséquent, l'extrémité et la longueur Lx du circuit à tester peuvent être détectées.

2. Dispositif selon la revendication 1, caractérisé en ce que entre la mémoire (2; Figure 2) et le champ d'affichage (3) est connectée une commande de transfert (24) qui transmet uniquement le contenu du circuit à tester au champ d'affichage et supprime la configuration de décalage y compris la transition de données (5).

3. Dispositif selon la revendication 1 et/ou 2, caractérisé en ce que les impulsions de décalage commandant le décalage de la configuration de décalage ou une partie de celle-ci ainsi que le décalage de l'information stockée dans le circuit dans la mémoire (2) sont générées par le générateur d'impulsions de décalage (20; Figure 3) qui est composé d'un oscillateur (30) et d'une porte ET (34) connectée à sa sortie, la sortie (21) de cette porte appliquant les impulsions de décalage au circuit à tester et à la mémoire, en ce que le générateur d'impulsions de décalage est en outre composé d'un compteur (31) qui comporte au moins Lmax +K positions de comptage et est incrémenté par les impulsions de l'oscillateur (30) et qui comporte une sortie (22) qui émet un signal lorsque le compteur produit la première valeur un, en ce que, en outre, le compteur est connecté à un dispositif de comparaison (32, 33) qui, lorsque la valeur Lmax +K est atteinte, émet un signal de sortie qui arrqui bloque la porte ET (34) à travers un circuit de négation (35) pour bloquer le transfert d'autres impulsions de décalage, et qui, sous forme d'impulsions de transfert commute la commande de transfert (24) à travers une ligne (27).

4. Dispositif selon l'une quelconque ou plusieurs des revendications 1 à 3, caractérisé en ce que l'arrangement (1; Figure 4) générant la configuration de décalage est composé d'une première porte ET (40) dont l'une des entrées (46) reçoit de façon permanente, une valeur correspondant au zéro binaire et dont l'autre entrée reçoit, à travers la ligne de sortie (22) du compteur (31), le signal identifiant la première position de comptage de celui-ci, en ce que en outre est prévue une seconde porte ET (42) dont une entrée (49) reçoit le signal inversé au moyen d'un circuit de négation (41) pour identifier le pas un du compteur et dont l'autre entrée (45) reçoit, de façon permanente, un signal correspondant au un binaire, et en ce que les sorties des premières et secondes portes ET sont connectées à une porte OU (43) dont la ligne de sortie (6) indique la configuration de décalage.

5. Dispositif selon l'une quelconque ou plusieurs des revendications 2 à 4, caractérisé en ce que la commande de transfert (24; Figure 5) connectée entre la mémoire (2) et le champ d'affichage (3) comporte pour chaque position (i) un élément de transfert (60, 70 ou 80) qui, en réponse à un signal de transfert transmet la valeur de la position (i) qui lui est associée, de la mémoire à la position correspondante (i) du champ d'affichage, si la valeur qui lui est associée se trouve dans une position (i-p) à la droite de la transition de données (5), la valeur p étant un nombre entier compris entre K et n +K.

6. Dispositif selon la revendication 5, caractérisé en ce que l'élément de transfert (60; Figure 6) de la première position (i=1) comporte trois lignes d'entrée (A, B, C) associées aux trois premiers étages (K1, K2, 1) dont la première représente l'entrée d'une première porte ET (62), la seconde représente l'entrée d'un circuit de négation (61), dont la sortie représente l'autre entrée de la première porte ET et dont la troisième représente la troisième entrée d'une seconde porte ET (63), dont la seconde entrée est formée par la sortie de la première porte ET et dont la première entrée est formée par la ligne d'impulsion de tranfert (27) et dont la sortie (56) est reliée à la première position du champ d'affichage (3), la sortie de la première porte ET étant connectée à une ligne de sortie (64) qui indique à tous les éléments de transfert (70, 80) adjacents du côté droit la présence d'une transition de données détecté par la première porte ET (62), la troisième ligne d'entrée (C) transmettant l'information associée à sa cellule de mémoire dans la mémoire (2) à la position associée du champ d'affichage (3) si cette position se trouve à droite du saut de données (5).

7. Dispositif selon la revendication 6, caractérisé en ce que, contrairement à l'élément de transfert (60) associé à la première position, les éléments de transfert (70, 80) associés à la seconde jusqu'à la nième position comporte une porte OU (71) connectée entre la ligne de sortie de la première porte ET (62) et l'entrée de la seconde porte ET (63), de sorte que l'une des entrées de la porte OU est connectée à la sortie de la première porte ET et sa sortie est connectée à la seconde entrée de la seconde porte ET, la ligne (64) étant connectée à l'autre entrée de la porte OU pour indiquer la transition de données, la ligne (64) continuant vers la droite étant connectée à la sortie de la porte OU.

**Claims**

1. A device for determining the length Lx of arbitrary shift registers (test objects) which do not exceed a predetermined maximum length Lmax, characterized by the following features:

— an arrangement (1) connected to the input (8; Fig. 1) of the test object (4) for generating a shift pattern of the length Lmax +K, with K≤2, which consists of a defined bit configuration (e.g., only binary ones) with a defined data transition (5) at its end facing the test object and which is shifted through the test object,

— a storage (2) of the length Lmax +K, which is connected to the output (9) of the test object and which, as the shift pattern is shifted, receives and stores the information on the length Lx of the test object and the part Lmax +K −Lx of the shift pattern, and
— a display field (3) whose individual fields (10) are each permanently associated with one cell (11) of the storage (2) and which indicates the contents of the cells, so that the data transition (5) and thus the end and the length Lx of the test object can be determined.

2. The device according to claim 1, characterized in that between the storage (2; Fig. 2) and the display field (3) a transfer control (24) is connected which transfers only the contents of the test object to the display field, suppressing the shift pattern including the data transition (5).

3. The device according to claim 1 and/or 2, characterized in that the shift pulses, which respectively control the shifting of the shift pattern and a part thereof and the shifting of the information stored in the test object into the storage (2), are generated by a shift pulse generator (20; Fig. 3) consisting of an oscillator (30) as well as an AND gate (34) connected to its output, the out (21) of the AND gate (34) applying the shift pulses to the test object and the storage, that the shift pulse generator also comprises a counter (31) with at least Lmax +K count positions, which is incremented by the pulses of the oscillator (30) and which has an output (22) emitting a signal whenever the counter generates the first count one, that, furthermore, the counter is connected to a comparator means (32, 33) which emits an output signal when the count value Lmax +K is reached, this output signal stopping the counter, blocking the AND gate (34) against the transfer of further shift pulses and as a transfer pulse switching the transfer control (24) via a line (27).

4. The device according to any one or combination of claims 1 to 3, characterized in that the arrangement (1; Fig. 4) for generating the shift pattern consists of a first AND gate (40), to one of whose inputs a value corresponding to the binary zero is permanently applied and to whose other input the signal identifying its first count position is applied via the output line (22) of the counter (31), that, furthermore, a second AND gate (42) is provided, to one input (49) of which the signal inverted by a negator (41) for identifying step one of the counter is applied and to the second input (45) of which a signal corresponding to the binary one is permanently applied, and that finally the outputs of the first and the second AND gate are connected to OR gate (43) whose output line (6) emits the shift pattern.

5. The device according to any one or combination of claims 2 to 4, characterized in that the transfer control (24; Fig. 5), connected between the storage (2) and the display field (3), comprises for each position (i) a transfer element (60, 70 or 80) which in response to a transfer signal transfers the value of the position (i) associated with it from the storage to the corresponding position (i) in the display field if the value associated with it is in a position (i-p) to the right of the data transition (5), where the value p is an integer between K and n +K.

6. The device according to claim 5, characterized in that the transfer element (60; Fig. 6) associated with the first position (i=1) has three input lines (A, B, C) associated with the first three stages (K1, K2, 1), the first input line of which forms an input of a first AND gate (62), the second input line of which forms the input of a negator (61), whose output represents the other input of the first AND gate, and the third input line of which forms the third input of a second AND gate (63) whose second input is formed by the output of the first AND gate and whose first input is formed by the transfer pulse line (27) and whose output (56) leads to the first position of the display field (3), wherein the output of the first AND gate is connected to an output line (64) notifying all adjacent transfer elements (70, 80) on the right of the presence of a data transition detected by the first AND gate (62), and wherein the third input line (C) transfers the information associated with its cell in storage (2) to the associated position in the display field (3) if this position is on the right of a data transition (5).

7. The device according to claim 6, characterized in that deviating from the transfer element (60) associated with the first position, the transfer elements (70, 80) associated with the second to nth position have an OR gate (71) which is connected to the connecting line between the output of the first AND gate (62) and the second input of the second AND gate (63) in such a manner that one input of the OR gate is connected to the output of the first AND gate and its output to the second input of the second AND gate, the connecting line (64) for notifying the data transition being connected to the other input of the OR gate, and wherein the connecting line (64) continuing to the right is connected to the output of the OR gate.

FIG. 1

FIG. 2

1

# FIG. 3

# FIG. 4

FIG. 5

0 009 099

FIG. 6

FIG. 7

FIG. 8

4